# EUROPÄISCHE PATENTSCHRIFT

(11) **EP 3 289 657 B1**
(45) Veröffentlichungstag und Bekanntmachung des Hinweises auf die Patenterteilung: **28.11.2018**
(21) Anmeldenummer: 16722566.3
(22) Anmeldetag: 28.04.2016
(51) Int. Cl.: H02J 3/38, G01R 31/40, H02M 3/04, H02M 7/44, H02S 50/10

(54) **VERFAHREN ZUM PRÜFEN DER STRÄNGE AN SOLARMODULEN EINER PHOTOVOLTAIKANLAGE UND PHOTOVOLTAIK-WECHSELRICHTER ZUR DURCHFÜHRUNG DES VERFAHRENS**
METHOD FOR CONTROLLING THE STRINGS OF SOLAR MODULES IN A PHOTOVOLTAIC INSTALLATION AND PHOTOVOLTAIC-INVERTER FOR IMPLEMENTING THE METHOD
PROCEDE POUR CONTROLER LES CHAINES DE MODULES SOLAIRES DANS UNE INSTALLATION PHOTOVOLTAÏQUE ET UN ONDULEUR PHOTOVOLTAÏQUE POUR L'APPLICATION DE LA METHODE

(30) Priorität: 30.04.2015 EP 15165968
(43) Veröffentlichungstag der Anmeldung: 07.03.2018
(73) Patentinhaber: Fronius International GmbH, 4643 Pettenbach (AT)
(72) Erfinder: RINGER, Thomas, 4710 Grieskirchen (AT); SCHWARZKOGLER, Hannes, 4652 Steinerkirchen/Traun (AT); SCHUBERT, Johannes, 4623 Gunskirchen (AT); SIEBERER, Thomas, 4870 Vöcklamarkt (AT)
(74) Vertreter: Sonn & Partner Patentanwälte
(86) Internationale Anmeldenummer: PCT/EP2016/059516
(87) Internationale Veröffentlichungsnummer: WO 2016/174150

(56) Entgegenhaltungen:
- EP-A2- 1 170 596
- DE-A1-102005 030 907
- DE-A1-102012 104 560
- JP-A- H1 063 358
- JP-A- 2013 065 797
- US-A1- 2014 188 410

## Beschreibung

Die Erfindung betrifft ein Verfahren zum Prüfen der Stränge einer Photovoltaikanlage, welche eine Gleichspannung erzeugen, mit zumindest einem Photovoltaik-Wechselrichter zur Umwandlung der Gleichspannung der Stränge in eine Wechselspannung zur Einspeisung in ein Versorgungsnetz und bzw. oder einen Verbraucher, mit jeweils zwei Anschlussleitungen pro Strang mit einer Steuereinrichtung, einem DC/DC-Wandler, einem Zwischenkreis, einem DC/AC-Wandler, und einem MPP-Tracker, wobei jeder Strang mit Hilfe von Schaltkontakten von integrierten Relais in jeder Anschlussleitung über die Steuereinrichtung einzeln zugeschaltet wird, um zumindest einzelne Werte der U/I-Kennlinie jedes Stranges durch an jeweils einer Anschlussleitung für jeden Strang angeordnete und im Photovoltaik-Wechselrichter integrierte Strommesseinrichtungen und durch eine Spannungsmesseinrichtung zu ermitteln, wobei jeder Strang einen Isolationswiderstand aufweist.

Weiters betrifft die Erfindung einen Photovoltaik-Wechselrichter zur Umwandlung der Gleichspannung der Stränge in eine Wechselspannung zur Einspeisung in ein Versorgungsnetz und bzw. oder einen Verbraucher, mit jeweils zwei Anschlussleitungen einer Steuereinrichtung, einem DC/DC-Wandler, einem Zwischenkreis, einem DC/AC-Wandler, und mit einem MPP-Tracker, wobei in jeder Anschlussleitung für jeden Strang ein Schaltkontakt eines integrierten Relais und in jeweils einer Anschlussleitung für jeden Strang jeweils eine Strommesseinrichtung angeordnet ist, und weiteres eine Spannungsmesseinrichtung zur Messung der Spannung jedes Stranges vorgesehen ist, wobei jeder Strang einen Isolationswiderstand aufweist.

Photovoltaikanlagen bestehen aus einer entsprechenden Anzahl an Solarmodulen die üblicherweise in Serie zu sogenannten Strängen bzw. Strings zusammengeschaltet werden und an den DC Eingang zumindest eines Wechselrichters angeschlossen werden. Der Photovoltaik-Wechselrichter wandelt die von den Solarmodulen erzeugte Gleichspannung in eine Wechselspannung um und stellt diese zur Einspeisung in ein Versorgungsnetz oder zur Versorgung von Verbrauchern zur Verfügung. Zur optimalen Ausnützung der Sonnenenergie wird mit Hilfe eines MPP (Maximum Power Point)-Trackers die Belastung eines Solarmoduls auf maximale Energieausbeute optimiert, indem zumindest einzelne Punkte der U/I-Kennlinie des Solarmoduls bzw. der Serienschaltung mehrerer Solarmodule ermittelt und der Wechselrichter so geregelt wird, dass das Solarmodul im sogenannten MPP (Maximum Power Point) betrieben wird, in welchem die zur Verfügung gestellte Leistung ein Maximum aufweist.

Abgesehen von den erwähnten Messungen an den Strängen an Solarmodulen während des Betriebs der Photovoltaikanlage sind weitere Verfahren zum Prüfen der Stränge an Solarmodulen einer Photovoltaikanlage vor der ersten Inbetriebnahme oder nach Veränderungen an der Photovoltaikanlage erforderlich bzw. vorgeschrieben. Üblicherweise werden derartige verpflichtende Inbetriebnahmeprüfungen mit externen Messgeräten und mit einem manuellen Eingriff in die Photovoltaikanlage durchgeführt. Dies ist mit einem entsprechend hohen zeitlichen und personellen Aufwand verbunden.

Beispielsweise beschreibt die DE 10 2012 214 177 A1 ein Verfahren zur Inbetriebnahme eines Wechselrichters einer Photovoltaikanlage, welches besonders einfach, kostengünstig und schnell und auch ohne Abschaltung der Photovoltaikanlage durchgeführt werden kann. Im Wesentlichen geht es dabei jedoch um die Bereitstellung von Daten und Informationen über eine Speicherkarte die zum Betrieb und für die Einstellung des Wechselrichters notwendig sind. Messungen zur Überprüfung des Zustands der Stränge an Solarmodulen bzw. Inbetriebnahmeprüfungen werden nicht vorgenommen.

Weitere Verfahren zum Prüfen der Stränge an Solarmodulen einer Photovoltaikanlage sind aus der JP 2013065797 A, der JP H10 63358 A, der DE 10 2012 104560 A1, der DE 10 2005 030907 A1 und der EP 1 170 596 A2 bekannt geworden. Aus den Messergebnissen ist kein Rückschluss möglich, die vom Hersteller garantierten Eigenschaften der Solarmodule zu überprüfen.

Die Aufgabe der vorliegenden Erfindung besteht in der Schaffung eines Prüfverfahrens nach Anspruch 1 und eines Wechselrichters nach Anspruch 6, durch welche eine Prüfung der Stränge an Solarmodulen möglichst rasch und effizient durchführbar ist. Nachteile bekannter Prüfverfahren und Wechselrichter sollen vermieden oder zumindest reduziert werden.

Gelöst wird die erfindungsgemäße Aufgabe durch ein oben genanntes Prüfverfahren, wobei die Polarität jedes Stranges an Solarmodulen sowie der Isolationswiderstand jedes Stranges ermittelt und in einem mit der Steuereinrichtung verbundenen Speicher gespeichert wird, danach der Einspeisebetrieb der Photovoltaikanlage begonnen und die zumindest einzelnen Werte der U/I-Kennlinie jedes Stranges an Solarmodulen automatisch und auf Befehl, in vorbestimmten Zeitabständen oder in Abhängigkeit bestimmter Betriebsereignisse oder Betriebsparameter ermittelt und gespeichert werden, und zusätzlich Umgebungsparameter im Bereich des Stranges gemessen und der Steuereinrichtung zugeführt werden, welche Werte im Speicher zum Erstellen eines Prüfberichts gespeichert werden und die ermittelten Werte gegebenenfalls auf Standard Test Conditions bei definierten Umgebungsbedingungen umgerechnet werden und mit im Speicher abgelegten Werten verglichen werden, und im Falle unzulässiger Abweichungen der ermittelten Werte und gegebenenfalls auf Standard Test Conditions umgerechneten Werten mit den im Speicher abgelegten Werten eine Warnung ausgegeben wird.

Das gegenständliche Prüfverfahren zeichnet sich dadurch aus, dass Messungen an allen Strängen an Solarmodulen ohne externe Messgeräte und ohne Eingriff in die Photovoltaikanlage von außen durchgeführt werden können. Durch die Schaltkontakte in jeder Anschlussleitung (sowohl der positiven als auch der negativen Leitung der Stränge an Solarmodulen) können alle Stränge an Solarmodulen hintereinander zugeschaltet bzw. weggeschaltet werden und somit einzeln vermessen werden. Die Schaltkontakte der Relais befinden sich üblicherweise im Wechselrichter d.h. in den Verbindungsleitungen der Anschlussleitungen für die Stränge mit dem DC/DC-Wandler des Wechselrichters. Diese Verbindungsleitungen können als Verlängerung der Anschlussleitungen gesehen werden. Es werden ja üblicherweise die Anschlussleitungen an einem Eingang eines Anschlussblocks angeklemmt, welcher meist einen sogenannten DC-Trenner aufweist und welcher am Ausgang mit den entsprechenden Komponenten des Wechselrichters verbunden ist. Diese Verbindung erfolgt bevorzugt direkt über eine Leiterbahn, auf welcher ebenso die Schaltkontakte angeordnet sind. Nach den Schaltkontakten sind die Anschlussleitungen gleicher Polarität zusammengeführt und mit dem DC/DC-Wandler mit nachfolgendem Zwischenkreis verbunden. Zur Durchführung der jeweiligen Messung an jedem Strang an Solarmodulen werden entsprechende im Photovoltaik-Wechselrichter integrierte Strommesseinrichtungen und zumindest eine Spannungsmesseinrichtung herangezogen, die ihre Messwerte an die Steuereinrichtung zur weiteren Verarbeitung zuführen. Die Messwerte und davon abgeleitete Werte werden in einem mit der Steuereinrichtung verbunden Speicher abgelegt. Von dort können die Werte zum Erstellen eines Prüfberichts auf Anforderung oder automatisch ausgelesen bzw. an gewünschte Stellen weitergeleitet werden. Das Prüfverfahren kann sowohl für die Inbetriebnahmeprüfung als auch die laufende Überwachung des Zustands jedes Strangs an Solarmodulen herangezogen werden. Zusätzlich zur Aufnahme zumindest einzelner Werte der U/I-Kennlinien der Stränge an Solarmodulen können auch Polaritätsmessungen und Messungen des Isolationswiderstands in besonders einfacher und rascher Weise vorgenommen werden. Die Dauer der Messung je Strang an Solarmodulen liegt im Bereich weniger Sekunden, insbesondere sogar unter 1 Sekunde, wohingegen herkömmliche Inbetriebnahmeprüfungen unter Verwendung externer Messgeräte und manueller Einflussnahme auf die Photovoltaikanlage ein Vielfaches an Zeit in Anspruch genommen haben. Das externe Messgerät müsste ja manuell mit jedem Strang verbunden werden. Im Gegensatz zu herkömmlichen Verfahren ist das gegenständliche Prüfverfahren aufgrund der Einfachheit und raschen Durchführbarkeit auch in regelmäßigen oder unregelmäßigen Zeitabständen im Betrieb der Photovoltaikanlage anwendbar und es können aus dem erstellten Prüfbericht wichtige Erkenntnisse über den Zustand der Stränge an Solarmodulen und deren Funktion abgeleitet werden. Durch die zusätzliche Messung von Umgebungsparametern im Bereich des Stranges der Solarmodule und der Zuführung der Messwerte an die Steuereinrichtung können wichtige zusätzliche Informationen in den Prüfbericht aufgenommen bzw. bei der Verarbeitung der Messwerte berücksichtigt werden. Für einen Vergleich der Messergebnisse mit den Angaben des Herstellers oder mit später durchgeführten Messergebnissen ist es wichtig, dass die Messungen unter vergleichbaren Umgebungsbedingungen im Bereich der Solarmodule stattgefunden haben.

Dadurch, dass die ermittelten Werte gegebenenfalls auf Standard Test Conditions bei definierten Umgebungsbedingungen umgerechnet werden und mit im Speicher abgelegten Werten verglichen werden, kann der Betreiber der Photovoltaikanlage über Fehlfunktionen oder alterungsbedingte Störungen informiert werden und eine Behebung der Störungen oder einen Austausch fehlerhafte Solarmodule veranlasst werden. Für solche Vergleiche kann sich eine Umrechnung der Werte auf sogenannte "Standard Test Conditions" auszeichnen. Standard Test Conditions sind vom Hersteller angegebene definierte Temperatur- und Einstrahlungsbedingungen, unter denen beispielsweise die Werte in den Datenblättern angegeben sind. Da diese Temperatur- und Einstrahlungsbedingungen nur selten zusammentreffen, werden meist vom Hersteller auch Umrechnungsformeln zur Umrechnung der Werte bei abweichender Temperatur bzw. Einstrahlung angegeben. Derart umgerechnete Werte können somit für Vergleiche mit erhöhter Aussagekraft herangezogen werden.

Die zumindest einzelnen Werte der U/I-Kennlinie jedes Stranges werden automatisch und auf Befehl, in vorbestimmten Zeitabständen oder in Abhängigkeit bestimmter Betriebsereignisse oder Betriebsparameter ermittelt und gespeichert werden. Das Prüfverfahren an jedem Strang kann aufgrund der besonders einfachen und raschen Durchführbarkeit wesentlich häufiger durchgeführt werden als es bei herkömmlichen Verfahren der Fall ist, die üblicherweise nur bei einer Inbetriebnahme der Anlage oder nach Veränderungen an der Anlage vorgenommen werden. Beispielsweise kann das Prüfverfahren auf Befehl bzw. Anforderung durchgeführt werden, welche Anforderung vor Ort oder auch von einer entfernten Stelle an die Photovoltaikanlage geschickt werden kann. Darüber hinaus kann eine Prüfung auch in vorbestimmten Zeitabständen beispielsweise einmal im Quartal oder einmal monatlich durchgeführt werden. Schließlich können auch bestimmte Betriebsereignisse oder Betriebsparameter eine Prüfung auslösen, wie zB bestimmte Umwelteinflüsse die mit entsprechenden Sensoren gemessen werden.

Weiters wird die Polarität jedes Stranges ermittelt und im Speicher gespeichert. Durch die Messung der Polarität jedes Stranges können vor Inbetriebnahme der Photovoltaikanlage oder nach Wartungsarbeiten an den Solarmodulen Verpolungen ermittelt und Schäden an der Photovoltaikanlage bzw an den Wechselrichtern oder Leistungseinbußen verhindert werden. Das Ergebnis der Polaritätsmessung kann in den Prüfbericht integriert werden.

Auch der Isolationswiderstand jedes Stranges wird ermittelt und im Speicher gespeichert, da dieser Parameter auch eine wichtige Aussage über den Zustand der Solarmodule liefert. Für die zuverlässige Messung des Isolationswiderstands jedes Stranges ist es unbedingt notwendig in jeder Anschlussleitung des Stranges einen Schaltkontakt eines Relais vorzusehen, sodass keine Isolationsfehler anderer Stränge das Messergebnis beeinflussen. Die gemessenen Isolationswiderstände jedes Stranges können ebenfalls in den Prüfbericht aufgenommen werden.

Im Falle unzulässiger Abweichungen der ermittelten Werte und gegebenenfalls auf Standard Test Conditions umgerechneten Werte mit den im Speicher abgelegten Werten wird eine Warnung ausgegeben, wodurch der Betreiber der Photovoltaikanlage rechtzeitig über Fehlfunktionen oder alterungsbedingte Störungen informiert wird und rasch eine Behebung der Störungen oder ein Austausch fehlerhafter Solarmodule veranlasst werden kann.

Vorteilhafterweise wird die vollständige U/I-Kennlinie einschließlich der Leerlaufspannung und des Kurzschlussstromes jedes Stranges ermittelt und im Speicher gespeichert. Aus der vollständigen U/I-Kennlinie jedes Stranges an Solarmodulen können wichtige Informationen über den Zustand der Solarmodule abgeleitet werden und beispielsweise überprüft werden, ob die Solarmodule die vom Hersteller garantierten Eigenschaften aufweisen.

Als Umgebungsparameter im Bereich des Stranges kann die Temperatur mit zumindest einem Temperatursensor gemessen und der Steuereinrichtung zugeführt werden. Weiters kann die Lichtstrahlung im Bereich des Stranges mit einem Einstrahlungssensor gemessen und der Steuereinrichtung zugeführt werden, um auch die Wetterbedingungen und Sonneneinstrahlungsbedingungen in die Messung einbeziehen zu können. Die Lichtstrahlung wird mit entsprechenden Sensoren an den Solarmodulen gemessen. Auch die Regenmenge im Bereich des Stranges kann mit einem Regensensor gemessen und der Steuereinrichtung zugeführt werden, um insbesondere für Messungen des Isolationswiderstandes eines Stranges die Einflussparameter zu berücksichtigen. Erfahrungsgemäß wird der Isolationswiderstand bei Regen herabgesetzt. Somit ist es für eine Fehlerbeurteilung wichtig auch die Feuchtigkeit bzw. Regenmenge während der Messung zu kennen.

Die im Speicher abgelegten Werte können an eine Datenschnittstelle, insbesondere Netzwerkschnittstelle, insbesondere eine Schnittstelle für das Internet, übertragen werden. Über eine solche Datenschnittstelle bzw. Netzwerkschnittstelle können die, während des Prüfverfahrens ermittelten und allenfalls davon abgeleitete Werte an entsprechende Stellen zu Dokumentationszwecken oder für statistische Verarbeitungen weitergeleitet werden. An derartigen externen Stellen können die gesammelten Prüfberichte noch weiter aufbereitet und den interessierten Kreisen zur Verfügung gestellt werden.

Gemäß einem weiteren Merkmal der Erfindung können die Werte auch automatisch an eine vorgegebene Adresse im Netzwerk, insbesondere Internet übertragen werden. Beispielsweise können bei Eintritt bestimmter Betriebsereignisse oder Betriebsparameter automatisch Prüfungsverfahren durchgeführt und an vorgegebene Empfänger übertragen werden wo die Werte weiter verarbeitet und allfällige Maßnahmen in die Wege geleitet werden können. Beispielsweise können die Prüfberichte auch automatisch per Email oder SMS an den Betreiber der Photovoltaikanlage gesendet werden.

Gelöst wird die erfindungsgemäße Aufgabe auch durch einen gegenständlichen Photovoltaik-Wechselrichter, bei dem jedes Relais, jede Strommesseinrichtung und die Spannungsmesseinrichtung mit der Steuereinrichtung verbunden ist, und die Steuereinrichtung dazu ausgebildet ist, jedes Relais, jede Strommesseinrichtung und die Spannungsmesseinrichtung derart zu steuern, dass die Polarität jedes Stranges sowie der Isolationswiderstand jedes Stranges ermittelbar ist, und nach Beginn der Einspeisung zumindest einzelne Werte der U/I-Kennlinie jedes Stranges automatisch und auf Befehl, in vorbestimmten Zeitabständen oder in Abhängigkeit bestimmter Betriebsereignisse oder Betriebsparameter zu ermitteln und zu speichern, und die Steuereinrichtung mit zumindest einer Schnittstelle zur Verbindung mit Sensoren zur Messung von Umgebungsparametern im Bereich des Stranges verbunden ist, und ein mit der Steuereinrichtung verbundener Speicher zum Ablegen der ermittelten Werte zum Erstellen eines Prüfberichts vorgesehen ist, und die Steuereinrichtung ferner dazu ausgebildet ist, die ermittelten Werte gegebenenfalls auf Standard Test Conditions bei definierten Umgebungsbedingungen umzurechnen und mit im Speicher abgelegten Werten zu vergleichen, und im Falle unzulässiger Abweichungen der ermittelten Werte und gegebenenfalls auf Standard Test Conditions umgerechneten Werten mit den im Speicher abgelegten Werten eine Wahrnung auszugeben. Der gegenständliche Photovoltaik-Wechselrichter ist durch die integrierten Relais, Strommesseinrichtung und zumindest eine Spannungsmesseinrichtung ohne Zuhilfenahme externer Messeinrichtungen im Stande Inbetriebnahmeprüfungen und Prüfungen des Zustands jedes Stranges an Solarmodulen automatisch durchzuführen. Die notwendigen Hardware- Komponenten sind relativ einfach und kostengünstig im Photovoltaik-Wechselrichter integrierbar. Die entsprechende Steuerung des Prüfverfahrens kann softwaretechnisch in der Steuerungseinrichtung implementiert werden. Bei größeren Photovoltaikanlagen mit einer Vielzahl an Photovoltaik-Wechselrichtern mit entsprechenden Einrichtungen zur Durchführung von Prüfverfahren können sämtliche Stränge automatisch rasch und somit unter identischen gleichen Umgebungsbedingungen vermessen werden, was bisher aufgrund der langen Messzeiten und/oder Umrüstzeiten nicht möglich war. Insbesondere bei großen Photovoltaikanlagen werden somit Prüfberichte jedes Stranges unter vergleichbaren Bedingungen, bezüglich der Temperatur und Einstrahlung allenfalls des Regens, geliefert. Bezüglich weiterer Vorteile des Photovoltaik-Wechselrichters wird auf die obige Beschreibung des Prüfverfahrens verwiesen. Die Steuereinrichtung ist mit zumindest einer Schnittstelle zur Verbindung mit Sensoren zur Messung von Umgebungsparametern im Bereich des Stranges verbunden, sodass die Umgebungsparameter im Bereich der Solarmodule in die Prüfung miteinbezogen werden können. Durch die zusätzliche Erfassung der Umgebungsbedingungen können die Messungen auch unter vorgeschriebenen Standardbedingungen (Standard Test Conditions STC) vorgenommen werden, unter welchen üblicherweise die vom Hersteller angegebene Daten der Solarmodule angegeben werden. Mit Hilfe des Prüfungsberichts können somit Abweichungen von garantierten Eigenschaften der Solarmodule identifiziert und an den Modulhersteller übermittelt werden.

Derartige Messungen und Überprüfungen, insbesondere zu regelmäßigen Zeiten während des Betriebs der Photovoltaikanlage, waren bisher nicht oder nur mit enormen Aufwand möglich.

Die Steuereinrichtung ist dazu ausgebildet, jedes Relais, jede Strommesseinrichtung und die Spannungsmesseinrichtung derart zu steuern, dass die Polarität jedes Stranges ermittelbar ist. Auf diese Weise kann eine Verpolung der Solarmodule rechtzeitig erkannt werden.

Weiters ist die Steuereinrichtung dazu ausgebildet, jedes Relais, jede Strommesseinrichtung und die Spannungsmesseinrichtung derart zu steuern, dass der Isolationswiderstandes jedes Stranges an Solarmodulen ermittelbar ist. Der Isolationswiderstand ist ein wichtiger Parameter für den Zustand des Solarmoduls.

Vorzugsweise ist die Steuereinrichtung dazu ausgebildet, jedes Relais, jede Strommesseinrichtung und die Spannungsmesseinrichtung derart zu steuern, die vollständige U/I-Kennlinie einschließlich der Leerlaufspannung und des Kurzschlussstromes jedes Stranges zu ermitteln und im Speicher zu speichern.

Die Steuereinrichtung kann mit zumindest einer Schnittstelle zur Verbindung mit einem Temperatursensor verbunden sein, sodass die Temperatur im Bereich der Solarmodule in die Prüfung miteinbezogen werden kann.

Weiters kann die Steuereinrichtung mit einer Schnittstelle zur Verbindung mit einem Einstrahlungssensor verbunden sein. Der Einstrahlungssensor ist an zumindest einem Solarmodul angeordnet und misst die von der Sonne gelieferte Lichteinstrahlung. Die Messung von Temperatur und Einstrahlung ermöglicht ein Umrechnen der aktuellen Werte auf Werte unter vom Hersteller angegebenen Standard Test Conditions STC, was einen Vergleich von Messwerten, die unter unterschiedlichen Umgebungsbedingungen erfasst worden sind, erlauben kann.

Schließlich ist es von Vorteil, wenn die Steuereinrichtung mit zumindest einer Schnittstelle zur Verbindung mit einem Regensensor verbunden ist. Wie bereits oben erwähnt ist die auf zusätzliche Erfassung des Regens bzw. der Luftfeuchtigkeit für die Messung des Isolationswiderstandes der Stränge von Bedeutung.

Die Steuereinrichtung kann auch mit einer Datenschnittstelle, insbesondere eine mit einem Netzwerk, insbesondere dem Internet verbindbaren Netzwerkschnittstelle verbunden sein. Über diese Datenschnittstelle bzw. Netzwerkschnittstelle kann der Prüfbericht und allenfalls weitere Messergebnisse an verschiedene Einrichtungen leitungsgebunden oder drahtlos übermittelt werden.

Die Spannungsmesseinrichtung kann durch die Spannungsmesseinrichtung des MPP-Trackers gebildet sein. Dadurch sinkt der hardwaretechnische Aufwand da für die Durchführung des Prüfverfahrens und die Ausstattung des Photovoltaik-Wechselrichters nur die Relais und die entsprechenden Schaltkontakte zum Zu- und Abschalten jedes Stranges und je Anschlussleitung eine Strommesseinrichtung erforderlich ist.

Die Erfindung wird anhand der beigefügten Zeichnungen näher erläutert. Darin zeigen
- Fig. 1: ein Blockschaltbild einer Photovoltaikanlage;
- Fig. 2: eine U/I-Kennlinie eines Stranges an Solarmodulen;
- Fig. 3: ein Flussdiagramm zur Veranschaulichung des Verfahrens zum Prüfen der Stränge an Solarmodulen einer Photovoltaikanlage; und
- Fig. 4: eine U/I-Kennlinie eines Stranges an Solarmodulen und unter verschiedenen Bedingungen.

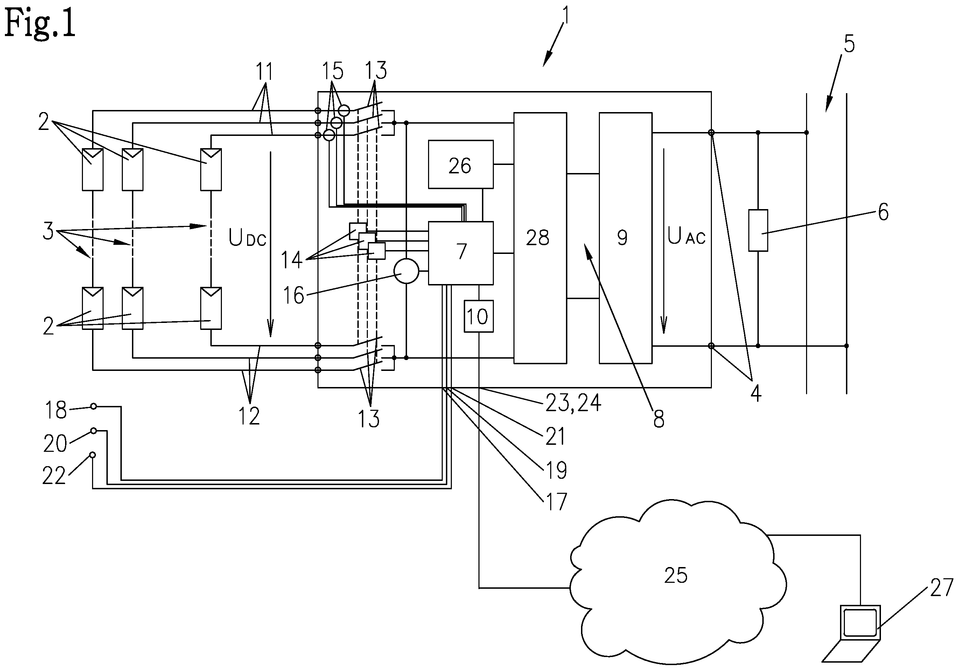

Fig. 1 zeigt ein Blockschaltbild einer Photovoltaikanlage, welche zumindest einen Photovoltaik-Wechselrichter 1 zur Umwandlung der Gleichspannung U_{DC} zumindest eines Solarmoduls 2 in eine Wechselspannung U_{AC} umwandelt. Üblicherweise werden mehrere Solarmodule 2 in Serie zu sogenannten Strängen 3 oder Strings zusammengeschaltet und an den DC Eingang des Photovoltaik-Wechselrichters 1 angeschlossen. In der Regel werden mehrere parallele Stränge 3 an einen Photovoltaik-Wechselrichter 1 angeschlossen. Bei größeren Photovoltaikanlagen werden entsprechend der Leistung der Anlage viele Photovoltaik-Wechselrichter 1 parallel angeordnet. Die vom Photovoltaik-Wechselrichter 1 erzeugte Wechselspannung U_{AC} wird über den AC-Ausgang 4 des Photovoltaik-Wechselrichters 1 an ein Versorgungsnetz 5 und bzw. oder einen Verbraucher 6 angeschlossen. Die Stränge 3 an Solarmodulen 2 sind über jeweils 2 Anschlussleitungen 11, 12 mit dem DC Eingang des Photovoltaik-Wechselrichters 1 verbunden. Der Photovoltaik-Wechselrichter 1 beinhaltet als Komponenten zumindest eine Steuereinrichtung 7, einen DC/DC-Wandler 28, einen Zwischenkreis 8, einen DC/AC-Wandler 9 und einen sogenannten MPP (Maximum Power Point)-Tracker 26, über den das Leistungsmaximum der Solarmodule 2 ermittelt werden kann, sodass der Photovoltaik-Wechselrichter 1 immer im sogenannten MPP (Maximum Power Point), also dem Leistungsmaximum der Solarmodule 2 betrieben werden kann. Entsprechend können die Komponenten auch zusammengefasst werden. Beispielsweise könnte der MPP-Tracker 26 auch die Funktion des DC/DC-Wandlers 28 erfüllen. Erfindungsgemäß ist in jeder Anschlussleitung 11, 12 jedes Stranges 3 an Solarmodulen 2 ein Schaltkontakt 13 eines Relais 14 angeordnet, sodass zur Durchführung des Prüfverfahrens ein Strang 3 an Solarmodulen 2 nach dem anderen zugeschaltet werden kann und somit der Zustand jedes Stranges 3 an Solarmodulen 2 einzeln und unabhängig von den weiteren Strängen 3 an Solarmodulen 2 gemessen werden kann. Das Prüfverfahren wird also schrittweise durchgeführt. Üblicherweise gehören die Schaltkontakte 13 in der positiven Anschlussleitung 11 und in der negativen Anschlussleitung 12 zu einem gemeinsamen Relais 14. Jedes Relais 14 ist mit der Steuereinrichtung 7 verbunden, sodass eine entsprechende Ansteuerung der Schaltkontake 13 und somit ein entsprechendes Zu- und Wegschalten der Stränge 3 an Solarmodulen 2 während des Prüfverfahrens erfolgen kann. Zusätzlich ist in jeweils einer Anschlussleitung 11 oder 12 jedes Stranges 3 an Solarmodulen 2 eine Strommesseinrichtung 15 angeordnet, über die der von allen in Serie geschalteten Solarmodulen 2 eines Stranges 3 zur Verfügung gestellte Strom ermittelt werden kann. Über eine Spannungsmesseinrichtung 16 wird die zur Verfügung gestellte Spannung aller Solarmodule 2 jedes Stranges 3 ermittelt. Die Strommesseinrichtung 15 und die Spannungsmesseinrichtung 16 sind ebenfalls mit der Steuereinrichtung 7 verbunden. Durch die im Photovoltaik-Wechselrichter 1 integrierten Strommesseinrichtung 15 und Spannungsmesseinrichtung 16 kann somit das Prüfverfahren der Stränge 3 an Solarmodulen 2 automatisch und rasch ohne Zuhilfenahme externer Messgeräte und einer manuellen Beeinflussung der Photovoltaikanlage durchgeführt werden. Die Spannungsmesseinrichtung 16 kann auch durch die üblicherweise im MPP-Tracker 26 integrierte Spannungsmesseinrichtung gebildet sein (nicht dargestellt). Die ermittelten Werte werden in einem Speicher 10 abgelegt wo sie zum Erstellen eines Prüfberichts gespeichert bleiben. Durch entsprechende Leistungsregelung können nicht nur einzelne Punkte der U/I-Kennlinie der Stränge 3 an Solarmodulen 2 sondern die vollständige U/I-Kennlinie jedes Stranges 3 von Solarmodulen 2 also einschließlich der Leerlaufspannung U_{LL} und des Kurzschlussstromes I_{KS} ermittelt und im Speicher 10 ermittelt werden.

Der dargestellte Photovoltaik-Wechselrichter 1 ermöglicht eine rasche Prüfung jedes Stranges 3 an Solarmodulen 2 innerhalb einer Sekunde oder darunter, was für die vorgeschriebene Inbetriebnahmeprüfung (also vor der ersten Einspeisung) einerseits, aber auch für die Prüfung der Anlage im laufenden Betriebe vorgenommen werden kann. Das Prüfverfahren kann manuell an einer Ein-/Ausgabe-Einrichtung (nicht dargestellt) der Photovoltaikanlage oder auf Befehl von außen ausgelöst werden, oder in vorbestimmten Zeitabständen Δt durchgeführt werden, oder auch in Abhängigkeit bestimmter Betriebsereignisse oder Betriebsparameter durchgeführt werden. Beispielsweise kann es automatisch vorgesehen werden, dass nach einer Abschaltung der Photovoltaikanlage oder bei bestimmten Umgebungsbedingungen wie zB bestimmten Temperaturen, Einstrahlungen oder Regensituationen eine Messung ausgelöst wird. Zur Ermittlung der Umgebungsparameter können Temperatursensoren 18, Einstrahlungssensoren 20 oder Regensensoren 22 über entsprechende Schnittstellen 17, 19 bzw. 21 mit dem Photovoltaik-Wechselrichter 1 bzw. dessen Steuereinrichtung 7 verbunden werden. Anhand der Umgebungsparameter kann eine Umrechnung auf Standard Test Conditions (STC) durchgeführt und gegebenenfalls abgespeichert werden. Somit ist es möglich, regelmäßig - und nicht zwingend bei STC Umgebungsparameter - die vom Hersteller garantierten Eigenschaften der Solarmodule 2 zu überprüfen. Ebenso können damit Rückschlüsse auf die maximal mögliche Leistung der Solarmodule 2 gezogen werden, wodurch Ertragseinbußen der Photovoltaikanlage frühzeitig erkannt werden können.

Um die im Speicher 10 gespeicherten Werte zum Erstellen des Prüfberichts auch entfernten Stellen zur Verfügung stellen zu können ist der Speicher 10 oder die Steuereinrichtung 7 vorzugsweise mit einer Datenschnittstelle 23 insbesondere einer Netzwerkschnittstelle 24 verbunden über die der Photovoltaik-Wechselrichter 1 mit einem Netzwerk insbesondere dem Internet 25 verbindbar ist. Somit können die im Speicher 10 abgelegten Werte zur Erstellung des Prüfberichts an jede Stelle insbesondere jeden ausgewählten Computer 27 im Netzwerk insbesondere Internet 25 zur Verfügung gestellt werden und dort weiterverarbeitet werden.

Zur Durchführung des Prüfverfahrens gehört insbesondere auch die Messung der Polarität jedes Stranges 3 an Solarmodulen 2 und die Messung des Isolationswiderstandes R_{I} jedes Stranges 3 am Solarmodul 2.

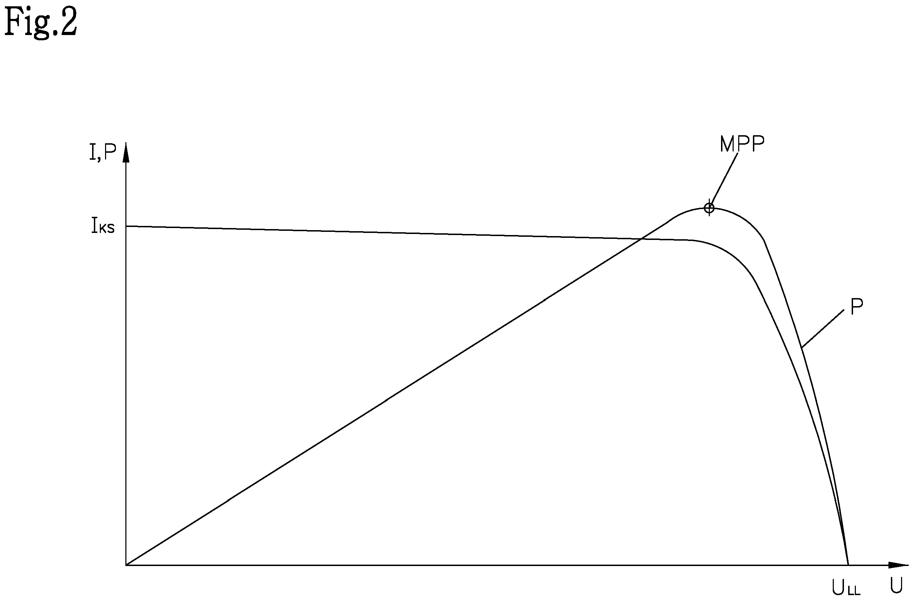

Fig. 2 zeigt eine übliche U/I-Kennlinie eines Solarmoduls und die zugehörige Leistungskurve. Die U/I-Kennlinie beginnt bei einem bestimmten Kurzschlussstrom I_{KS} und verläuft sinkend zu einer Leerlaufspannung U_{LL}. In einem bestimmten Punkt der U/I-Kennlinie liefert das Solarmodul bzw. die Serienschaltung mehrerer Solarmodule die maximale Leistung. Dieser anzustrebende Arbeitspunkt wird MPP (Maximum Power Point) genannt. Mit Hilfe sogenannter MPP Tracker die üblicherweise im Photovoltaik-Wechselrichter integriert sind, wird die Kennlinie des Solarmoduls bzw. der Serienschaltung mehrerer Solarmodule zumindest teilweise ermittelt und eine Regelung vorgenommen, sodass das Solarmodul im MPP betrieben wird.

Mit Hilfe des gegenständlichen Prüfverfahrens und den entsprechend ausgestatteten Photovoltaik-Wechselrichtern ist es möglich zumindest einen Teil der U/I-Kennlinie vorzugsweise die gesamte U/I-Kennlinie einschließlich Kurzschlussstrom I_{KS} und Leerlaufspannung U_{LL} vor Inbetriebnahme der Photovoltaikanlage aber auch während des laufenden Betriebs zu erfassen und somit ein verpflichtendes Prüfprotokoll zu erstellen oder Veränderungen der Solarmodule beispielsweise aufgrund von Verunreinigungen, Witterungseinflüssen oder der Alterung zu erkennen. Die dabei produzierte Leistung kann entsprechend in das Versorgungsnetz eingespeist werden.

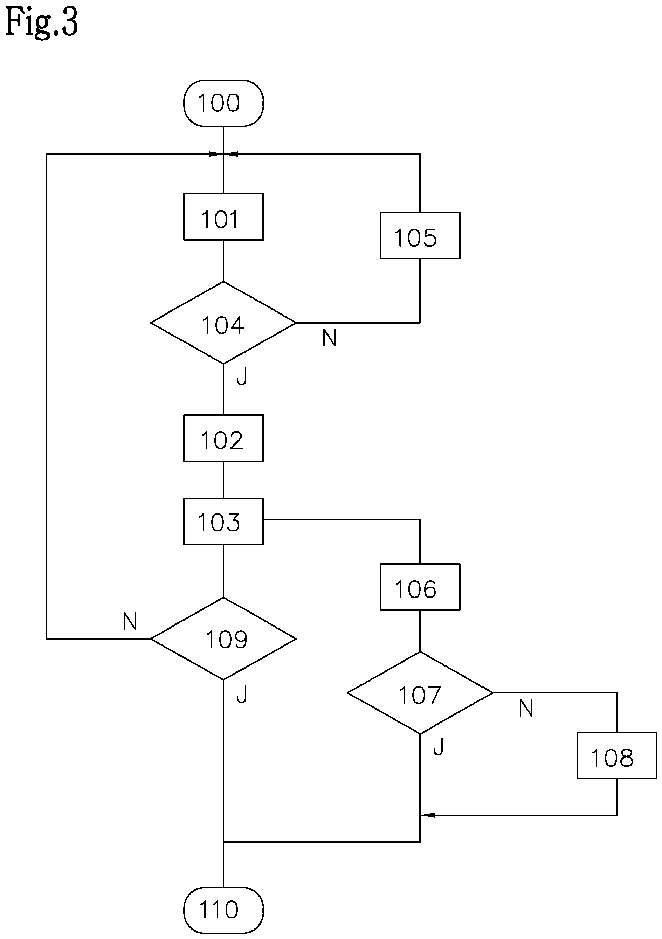

Fig. 3 zeigt ein Flussdiagramm des erfindungsgemäßen Verfahrens zur Prüfung der Stränge an Solarmodulen einer Photovoltaikanlage. Nach dem Start des Verfahrens (Block 100) wird eine Prüfung der Polarität jedes Stranges an Solarmodulen (Block 101) durchgeführt. Danach wir der der Isolationswiderstand R_{I} jedes Stranges an Solarmodulen (Block 102) gemessen. Danach wird der Einspeisebetrieb der Photovoltaikanlage begonnen und die U/I-Kennlinie jedes Stranges an Solarmodulen zumindest teilweise vorzugsweise vollständig (einschließlich Kurzschlussstrom I_{KS} und Leerlaufspannung U_{LL}) ermittelt (Block 103). Nach der Polaritätsmessung (Block 101) erfolgt üblicherweise eine Abfrage (Block 104) ob die Polarität korrekt ist und es wird nur im Falle einer korrekten Polarität des Stranges an Solarmodulen mit der Messung fortgefahren. Bei Feststellung einer Verpolung erfolgt eine entsprechende Warnung (Block 105) und es wird an den Beginn der Messung zurückgesprungen oder die Messung solange unterbrochen bis die korrekte Polarität hergestellt wurde. Nach der Erfassung der U/I-Kennlinie sämtlicher Stränge an Solarmodulen werden die entsprechenden Werte in den Speicher geschrieben (Block 106) und zur Erstellung eines Prüfberichts zur Verfügung gestellt. Optional können die im Speicher abgelegten Werte mit Grenzwerten oder vorausgegangenen Werte verglichen werden (Abfrage 107) und im Falle unzulässiger Abweichungen eine Warnung (Block 108) ausgegeben werden. Gemäß Abfrage 109 wird die Messung bzw. das Prüfverfahren unter bestimmten Bedingungen wie zB nach Eintritt bestimmter Betriebsereignisse oder nach Ablauf voreingestellter Zeitdauern Δt wieder begonnen. Entsprechend Schritt 110 wird das Messverfahren beendet.

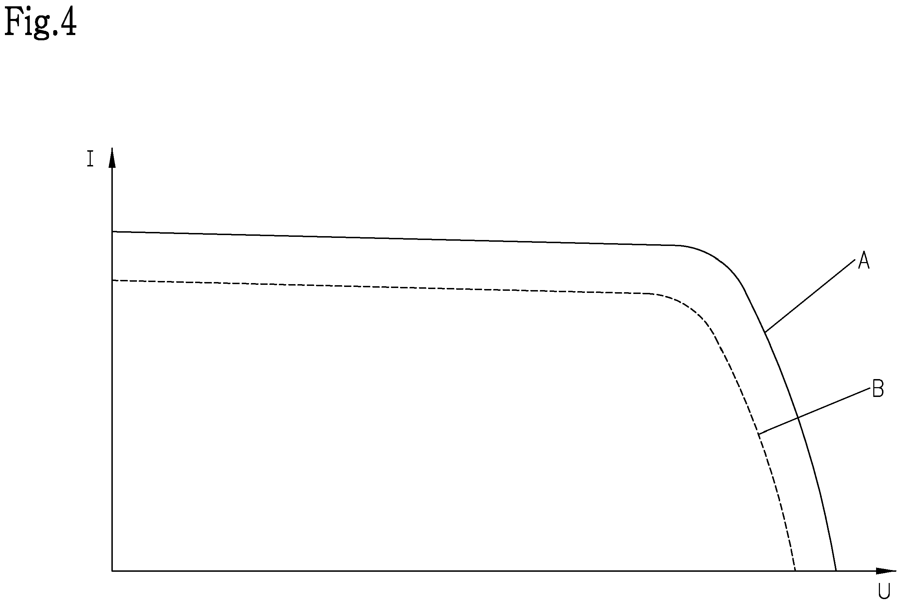

Schließlich zeigt Fig. 4 eine U/I-Kennlinie eines Solarmoduls unter verschiedenen Bedingungen. Die Kennlinie A ist für ein neues Solarmodul charakteristisch während die Kurve B die Eigenschaften eines gealterten Solarmoduls zeigt. Bei wiederholter Messung und Überprüfung aller Stränge an Solarmodulen kann somit die Alterung des Solarmoduls effektiv festgestellt werden und bei Unterschreitung bestimmter Schwellwerte ein rechtzeitiger Austausch des Solarmoduls veranlasst werden, sodass wieder die optimale Leistung aus der Sonnenenergie erhalten werden kann. Gerade bei solchen Messungen und Vergleichen ist die Messung bei bzw. Umrechnung auf die Standard Test Conditions bei definierter Temperatur und Einstrahlung von besonderer Bedeutung.

## Patentansprüche

1. Verfahren zum Prüfen der Stränge (3) einer Photovoltaikanlage, welche eine Gleichspannung (U_{DC}) erzeugen, mit zumindest einem Photovoltaik-Wechselrichter (1) zur Umwandlung der Gleichspannung (U_{DC}) der Stränge (3) in eine Wechselspannung (U_{AC}) zur Einspeisung in ein Versorgungsnetz (5) und bzw. oder einen Verbraucher (6), mit jeweils zwei Anschlussleitungen (11, 12) pro Strang (3), mit einer Steuereinrichtung (7), einem DC/DC-Wandler (28), einem Zwischenkreis (8), einem DC/AC-Wandler (9), und einem MPP-Tracker (26), wobei jeder Strang (3) mit Hilfe von Schaltkontakten (13) von integrierten Relais (14) in jeder Anschlussleitung (11, 12) über die Steuereinrichtung (7) einzeln zugeschaltet wird, um zumindest einzelne Werte der U/I-Kennlinie jedes Stranges (3) durch an jeweils einer Anschlussleitung (11) für jeden Strang (3) angeordnete und im Photovoltaik-Wechselrichter (1) integrierte Strommesseinrichtungen (15) und durch eine Spannungsmesseinrichtung (16) zu ermitteln, wobei jeder Strang (3) einen Isolationswiderstand (R_{I}) aufweist, **dadurch gekennzeichnet, dass** die Polarität jedes Stranges (3) an Solarmodulen (2) sowie der Isolationswiderstand (R_{I}) jedes Stranges (3) ermittelt und in einem mit der Steuereinrichtung (7) verbundenen Speicher (10) gespeichert wird, danach der Einspeisebetrieb der Photovoltaikanlage begonnen und die zumindest einzelnen Werte der U/I-Kennlinie jedes Stranges (3) an Solarmodulen (2) automatisch und auf Befehl, in vorbestimmten Zeitabständen (Δt) oder in Abhängigkeit bestimmter Betriebsereignisse oder Betriebsparameter ermittelt und gespeichert werden, und dass zusätzlich Umgebungsparameter im Bereich des Stranges (3) gemessen und der Steuereinrichtung (7) zugeführt werden, welche Werte im Speicher (10) zum Erstellen eines Prüfberichts gespeichert werden und die ermittelten Werte gegebenenfalls auf Standard Test Conditions (STC) bei definierten Umgebungsbedingungen umgerechnet werden und mit im Speicher (10) abgelegten Werten verglichen werden, und im Falle unzulässiger Abweichungen der ermittelten Werte und gegebenenfalls auf Standard Test Conditions (STC) umgerechneten Werten mit den im Speicher (10) abgelegten Werten eine Warnung ausgegeben wird.

2. Prüfverfahren nach Anspruch 1, **dadurch gekennzeichnet, dass** die vollständige U/I-Kennlinie einschließlich der Leerlaufspannung (U_{LL}) und des Kurzschlussstromes (I_{KS}) jedes Stranges (3) ermittelt und im Speicher (10) gespeichert werden.

3. Prüfverfahren nach Anspruch 1 oder 2, **dadurch gekennzeichnet, dass** als Umgebungsparameter die Temperatur, die Lichtstrahlung und bzw. oder die Regenmenge im Bereich des Stranges (3) mit zumindest einem Temperatursensor (18), einem Einstrahlungssensor (20) und bzw. oder einem Regensensor (22) gemessen wird.

4. Prüfverfahren nach einem der Ansprüche 1 bis 3, **dadurch gekennzeichnet, dass** die im Speicher (10) abgelegten Werte an eine Datenschnittstelle (23), insbesondere Netzwerkschnittstelle (24), insbesondere eine Schnittstelle für das Internet (25), übertragen werden.

5. Prüfverfahren nach Anspruch 4, **dadurch gekennzeichnet, dass** die Werte automatisch an eine vorgegebene Adresse im Netzwerk, insbesondere Internet (25) übertragen werden.

6. Photovoltaik-Wechselrichter (1) zur Umwandlung der Gleichspannung (U_{DC}) der Stränge (3) in eine Wechselspannung (U_{AC}) zur Einspeisung in ein Versorgungsnetz (5) und bzw. oder einen Verbraucher (6), mit jeweils zwei Anschlussleitungen (11, 12), einer Steuereinrichtung (7), einem DC/DC-Wandler (28), einem Zwischenkreis (8) einem DC/AC-Wandler (9), und mit einem MPP-Tracker (26), wobei in jeder Anschlussleitung (11, 12) für jeden Strang (3) ein Schaltkontakt (13) eines integrierten Relais (14) und in jeweils einer Anschlussleitung (11) für jeden Strang (3) jeweils eine Strommesseinrichtung (15) angeordnet ist, und weiters eine Spannungsmesseinrichtung (16) zur Messung der Spannung (U) jedes Stranges (3) vorgesehen ist, wobei jeder Strang (3) einen Isolationswiderstand (R_{I}) aufweist, **dadurch gekennzeichnet, dass** jedes Relais (14), jede Strommesseinrichtung (15) und die Spannungsmesseinrichtung (16) mit der Steuereinrichtung (7) verbunden ist, und die Steuereinrichtung (7) dazu ausgebildet ist, jedes Relais (14), jede Strommesseinrichtung (15) und die Spannungsmesseinrichtung (16) derart zu steuern, dass die Polarität jedes Stranges (3) sowie des Isolationswiderstandes (R_{I}) jedes Stranges (3) ermittelbar ist, und nach Beginn der Einspeisung zumindest einzelne Werte der U/I-Kennlinie jedes Stranges (3) automatisch und auf Befehl, in vorbestimmten Zeitabständen (Δt) oder in Abhängigkeit bestimmter Betriebsereignisse oder Betriebsparameter zu ermitteln und zu speichern, und dass die Steuereinrichtung (7) mit zumindest einer Schnittstelle (17) zur Verbindung mit Sensoren zur Messung von Umgebungsparametern im Bereich des Stranges (3) verbunden ist, und dass ein mit der Steuereinrichtung (7) verbundener Speicher (10) zum Ablegen der ermittelten Werte zum Erstellen eines Prüfberichts vorgesehen ist, und dass die Steuereinrichtung (7) ferner dazu ausgebildet ist, die ermittelten Werte gegebenenfalls auf Standard Test Conditions (STC) bei definierten Umgebungsbedingungen umzurechnen und mit im Speicher (10) abgelegten Werten zu vergleichen, und im Falle unzulässiger Abweichungen der ermittelten Werte und gegebenenfalls auf Standard Test Conditions (STC) umgerechneten Werten mit den im Speicher (10) abgelegten Werten eine Warnung auszugeben.

7. Photovoltaik-Wechselrichter (1) nach Anspruch 6, **dadurch gekennzeichnet, dass** die Steuereinrichtung (7) dazu ausgebildet ist, jedes Relais (14), jede Strommesseinrichtung (15) und die Spannungsmesseinrichtung (16) derart zu steuern, die vollständige U/I-Kennlinie einschließlich der Leerlaufspannung (U_{LL}) und des Kurzschlussstromes (I_{KS}) jedes Stranges (3) zu ermitteln und im Speicher (10) zu speichern.

8. Photovoltaik-Wechselrichter (1) nach Anspruch 6 oder 7, **dadurch gekennzeichnet, dass** die Steuereinrichtung (7) mit zumindest einer Schnittstelle (17) zur Verbindung mit einem Temperatursensor (18), mit einer Schnittstelle (19) zur Verbindung mit einem Einstrahlungssensor (20) und bzw. oder zumindest einer Schnittstelle (21) zur Verbindung mit einem Regensensor (22) verbunden ist.

9. Photovoltaik-Wechselrichter (1) nach einem der Ansprüche 6 bis 8, **dadurch gekennzeichnet, dass** die Steuereinrichtung (7) mit einer Datenschnittstelle (23), insbesondere eine mit einem Netzwerk, insbesondere dem Internet (25), verbindbaren Netzwerkschnittstelle (24) verbunden ist.

## Claims

1. Method for testing the strings (3) of a photovoltaic system, which strings generate a DC voltage (U_{DC}), the system comprising at least one photovoltaic converter (1) for converting the DC voltage (U_{DC}) of the strings (3) into an AC voltage (U_{AC}) for feeding into a supply network (5) and/or a load (6), having two connecting lines (11, 12) for each string (3), comprising a control device (7), a DC-to-DC converter (28), an intermediate circuit (8), a DC-to-AC converter (9) and an MPP tracker (26), each string (3) being individually connected via the control device (7) by means of switching contacts (13) of integrated relays (14) in each connecting line (11, 12), in order to detect at least individual values of the U/I characteristic curve of each string (3) by means of current measuring devices (15) arranged on one connecting line (11) for each string (3) and integrated in the photovoltaic converter (1) and by means of a voltage measuring device (16), each string (3) having an insulation resistance (R_{I}), **characterised in that** the polarity of each string (3) on solar modules (2) and the insulation resistance (R_{I}) of each string (3) is detected and stored in a memory (10) connected to the control device (7), the feeding operation of the photovoltaic system is subsequently started and the at least individual values of the U/I characteristic curve of each string (3) on solar modules (2) are detected and stored automatically and on command, at specified time intervals (Δt) or depending on specific operating events or operating parameters, and **in that** environmental parameters in the region of the string (3) are additionally measured and supplied to the control device (7), which values are stored in the memory (10) in order to produce a test report and the detected values are optionally converted to Standard Test Conditions (STC) under defined environmental conditions and are compared with values stored in the memory (10), and if there are impermissible deviations of the detected values and values optionally converted to Standard Test Conditions (STC) to the values stored in the memory (10), a warning is issued.

2. Test method according to claim 1, **characterised in that** the complete U/I characteristic curve including the open-circuit voltage (U_{LL}) and the short-circuit current (I_{KS}) of each string (3) are detected and stored in the memory (10).

3. Test method according to either claim 1 or claim 2, **characterised in that** the temperature, the luminous radiation and/or the amount of rain in the region of the string (3) is measured, as environmental parameters, by means of at least one temperature sensor (18), one irradiation sensor (20) and/or one rain sensor (22).

4. Test method according to any of claims 1 to 3, **characterised in that** the values stored in the memory (10) are transmitted to a data interface (23), in particular a network interface (24), in particular an interface for the Internet (25).

5. Test method according to claim 4, **characterised in that** the values are automatically transmitted to a specified address in the network, in particular in the Internet (25).

6. Photovoltaic converter (1) for converting the DC voltage (U_{DC}) of the strings (3) into an AC voltage (U_{AC}) for feeding into a supply network (5) and/or a load (6), having two connecting lines (11, 12) in each case, a control device (7), a DC-to-DC converter (28), an intermediate circuit (8), a DC-to-AC converter (9) and an MPP tracker (26), a switching contact (13) of an integrated relay (14) being arranged in each connecting line (11, 12) for each string (3) and a current measuring device (15) being arranged in one connecting line (11) for each string (3), and furthermore a voltage measuring device (16) being provided for measuring the voltage (U) of each string (3), each string (3) having an insulation resistance (R_{I}), **characterised in that** each relay (14), each current measuring device (15) and the voltage measuring device (16) is connected to the control device (7), and the control device (7) is configured to control each relay (14), each current measuring device (15) and the voltage control device (16) such that the polarity of each string (3) and of the insulation resistance (R_{I}) of each string (3) can be detected, and, after feeding in has started, to detect and store at least individual values of the U/I characteristic curve of each string (3) automatically and on command, at specified time intervals (Δt) or depending on specific operating events or operating parameters, and **in that** the control device (7) is connected to at least one interface (17) for connection to sensors for measuring environmental parameters in the region of the string (3), and **in that** a memory (10) connected to the control device (7) is provided for storing the detected values in order to produce a test report, and **in that** the control device (7) is further configured to optionally convert the detected values to Standard Test Conditions (STC) under defined environmental conditions and to compare said values to values stored in the memory (10), and to issue a warning if there are impermissible deviations of the detected values and values optionally converted to Standard Test Conditions (STC) to the values stored in the memory (10).

7. Photovoltaic converter (1) according to claim 6, **characterised in that** the control device (7) is configured to control each relay (14), each current measuring device (15) and the voltage measuring device (16) so as to detect the complete U/I characteristic curve including the open-circuit voltage (U_{LL}) and the short-circuit current (I_{KS}) of each string (3) and store said characteristic curve including the open-circuit voltage and the short-circuit current in the memory (10).

8. Photovoltaic converter (1) according to either claim 6 or claim 7, **characterised in that** the control device (7) is connected to at least one interface (17) for connection to a temperature sensor (18), to an interface (19) for connection to an irradiation sensor (20), and/or to at least one interface (21) for connection to a rain sensor (22).

9. Photovoltaic converter (1) according to any of claims 6 to 8, **characterised in that** the control device (7) is connected to a data interface (23), in particular to a network interface (24) that can be connected to a network, in particular to the Internet (25).

## Revendications

1. Procédé de vérification des branches (3) d'une installation photovoltaïque, qui génèrent une tension continue (U_{DC}), avec au moins un onduleur photovoltaïque (1) pour la conversion de la tension continue (U_{DC}) des branches (3) en une tension alternative (U_{AC}) destinée à être introduite dans un réseau d'alimentation (5) et/ou dans un consommateur (6), avec chacun deux lignes de raccordement (11, 12) par branche (3), avec un dispositif de commande (7), un convertisseur DC/DC (28), un circuit intermédiaire (8), un convertisseur DC/AC (9) et un traceur MPP (26), chaque branche (3) étant activée individuellement à l'aide de contacts de commutation (13) de relais intégrés (14) dans chaque ligne de raccordement (11, 12) par l'intermédiaire du dispositif de commande (7), afin de déterminer au moins certaines valeurs de la courbe caractéristique U/I de chaque branche (3) à l'aide de dispositifs de mesure de courant (15) disposés chacun sur une ligne de commande (11) de chaque branche (3) et intégrés dans l'onduleur photovoltaïque (1) et à l'aide d'un dispositif de mesure de tension (16), chaque branche (3) comprenant une résistance d'isolation (R_{I}), **caractérisé en ce que** la polarité de chaque branche (3) ainsi que la résistance d'isolation (R_{I}) de chaque branche (3) est déterminée et enregistrée au niveau de modules solaires (2) dans une mémoire (10) reliée au dispositif de commande (7), puis le fonctionnement d'alimentation de l'installation photovoltaïque est commencé et les au moins certaines valeurs de la courbe caractéristique U/I de chaque branche (3) sont déterminées et enregistrées au niveau de modules solaires (2) de manière automatique et sur demande, à des intervalles prédéterminés (Δt) ou en fonction d'événements de fonctionnement ou de paramètres de fonctionnement déterminés, et **en ce que**, en outre, des paramètres environnementaux sont mesurés au niveau de la branche (3) et introduits dans le dispositif de commande (7), ces valeurs étant enregistrées dans la mémoire (10) pour l'établissement d'un rapport de vérification et les valeurs déterminées sont le cas échéant converties en Standard Test Conditions (STC) à des conditions environnementales définies et comparées avec des valeurs enregistrées dans la mémoire (10) et, dans le cas d'écarts inadmissibles des valeurs déterminées et, le cas échéant, des valeurs converties en Standard Test Conditions (STC) avec les valeurs enregistrées dans la mémoire (10), un avertissement est émis.

2. Procédé de vérification selon la revendication 1, **caractérisé en ce que** la courbe caractéristique U/I complète, y compris la tension à vide (U_{LL}) et le courant de court-circuit (I_{KS}) de chaque branche (3) sont déterminées et enregistrées dans la mémoire (10).

3. Procédé de vérification selon la revendication 1 ou 2, **caractérisé en ce que**, en tant que paramètre environnemental, la température, le rayonnement lumineux et/ou la quantité de pluie au niveau de la branche (3) est mesuré avec au moins un capteur de température (18), un capteur de rayonnement (20) et/ou un capteur de pluie (22).

4. Procédé de vérification selon l'une des revendications 1 à 3, **caractérisé en ce que** les valeurs enregistrées dans la mémoire (10) sont transmises à une interface de données (23), plus particulièrement une interface réseau (24), plus particulièrement une interface pour Internet (25).

5. Procédé de vérification selon la revendication 4, **caractérisé en ce que** les valeurs sont automatiquement transmises à une adresse prédéterminée dans le réseau, plus particulièrement sur Internet (25).

6. Onduleur photovoltaïque (1) pour la conversion de la tension continue (U_{DC}) des branches (3) en une tension alternative (U_{AC}) destinée à être introduite dans un réseau d'alimentation (5) et/ou un consommateur (6), avec chacune deux lignes de raccordement (11, 12), un dispositif de commande (7), un convertisseur DC/DC (28), un circuit intermédiaire (8), un convertisseur DC/AC (9) et un traceur MPP (26), moyennant quoi, dans chaque ligne de raccordement (11, 12), pour chaque branche (3), est disposé un contact de commutation (13) d'un relais (14) intégré et dans une ligne de raccordement (11), pour chaque branche (3), est disposé un dispositif de mesure de courant (15) et en outre un dispositif de mesure de tension (16) pour la mesure de la tension (U) de chaque branche (3) est prévu, chaque branche (3) comprenant une résistance d'isolation (R_{I}), **caractérisé en ce que** chaque relais (14), chaque dispositif de mesure de courant (15) et le dispositif de mesure de tension (16) est relié au dispositif de commande (7) et le dispositif de commande (7) est conçu pour contrôler chaque relais (14), chaque dispositif de mesure de courant (15) et le dispositif de mesure de tension (16) de façon à ce que la polarité de chaque branche (3) ainsi que de la résistance d'isolation (R_{I}) de chaque branche (3) puisse être déterminée et, après le début de l'alimentation, au moins certaines valeurs de la courbe caractéristique U/I de chaque branche (3) doivent être déterminées et enregistrées automatiquement et sur demande, à des intervalles prédéterminés (Δt) ou en fonction d'événements de fonctionnement ou de paramètres de fonctionnement déterminés et **en ce que** le dispositif de commande (7) est relié avec au moins une interface (17) pour la liaison avec des capteurs pour la mesure de paramètres environnementaux au niveau de la branche (3), et **en ce qu'**une mémoire (10) reliée au dispositif de commande (7) est prévue pour l'enregistrement des valeurs déterminées pour l'établissement d'un rapport de vérification et **en ce que** le dispositif de commande (7) est en outre conçu pour convertir, le cas échéant, les valeurs déterminées en Standard Test Conditions (STC) à des conditions environnementales définies et les comparer à des valeurs enregistrées dans la mémoire (10) et, dans le cas d'écarts inadmissibles entre les valeurs déterminées et, le cas échéant, converties en Standard Test Conditions (STC) et les valeurs enregistrées dans la mémoire (10), pour émettre un avertissement.

7. Onduleur photovoltaïque (1) selon la revendication 6, **caractérisé en ce que** le dispositif de commande (7) est conçu pour contrôler chaque relais (14), chaque dispositif de mesure de courant (15) et le dispositif de mesure de tension (16) de façon à déterminer la courbe caractéristique U/I complète, y compris la tension à vide (U_{LL}) et le courant de court-circuit (I_{KS}) de chaque branche (3) et pour les enregistrer dans la mémoire (10).

8. Onduleur photovoltaïque (1) selon la revendication 6 ou 7, **caractérisé en ce que** le dispositif de commande (7) est relié avec au moins une interface (17) pour la liaison avec un capteur de température (18), avec une interface (19) pour la liaison avec un capteur de rayonnement (20) et/ou au moins une interface (21) pour la liaison avec un capteur de pluie (22).

9. Onduleur photovoltaïque (1) selon l'une des revendications 6 à 8, **caractérisé en ce que** le dispositif de commande (7) est relié avec une interface de données (23), plus particulièrement une interface de réseau (24) pouvant être reliée à un réseau, plus particulièrement Internet (25).
